# EUROPÄISCHE PATENTANMELDUNG

(11) **EP 2 388 603 A1**
(43) Veröffentlichungstag der Anmeldung: **23.11.2011**
(21) Anmeldenummer: 10163133.1
(22) Anmeldetag: 18.05.2010
(51) Int. Cl.: G01R 31/02, G01R 31/04, G01R 31/26, G01R 31/28

(54) **Verfahren und Vorrichtung zur Überwachung von Kontakten einer Photovoltaikanlage**

(71) Anmelder: SMA Solar Technology AG, 34266 Niestetal (DE); Universität Kassel, 34125 Kassel (DE)
(72) Erfinder: Brabetz, Prof. Dr. rer. nat. Ludwig, 38165 Lehre (DE); Haas, Dr.-Ing. Oliver, 34128 Kassel (DE); Ayeb, Dr.-Ing. Mohamed, 34130 Kassel (DE); Bettenwort, Dr.-Ing. Gerd, 34119 Kassel (DE)
(74) Vertreter: Specht, Peter

(57) **Zusammenfassung**

Ein Verfahren zur Überwachung von Kontakten einer Photovoltaikanlage (1), weist folgende Verfahrensschritte auf: Einkoppeln eines Testsignals in die Photovoltaikanlage (1), wobei die Frequenz des Testsignals während des Einkoppelns verändert wird, Auskoppeln des Testsignals aus der Photovoltaikanlage (1) und Ermitteln einer Impedanz der Photovoltaikanlage (1) mittels einer Auswertung des ausgekoppelten Testsignals, und Überwachen von Kontakten der Photovoltaikanlage (1) durch Ermitteln eines Widerstands der Photovoltaikanlage (1) anhand der ermittelten Impedanz, wobei die Verfahrensschritte vorzugsweise bei Dämmerung und/oder Dunkelheit ausgeführt werden. Eine entsprechende Vorrichtung (2) dient zur Durchführung des Verfahrens.

## Beschreibung

Die Erfindung betrifft ein Verfahren zur Überwachung von Kontakten einer Photovoltaikanlage und eine entsprechende Vorrichtung.

Eine Photovoltaikanlage stellt mittels Photovoltaik elektrische Energie zur Verfügung.

Im Betrieb der Photovoltaikanlagen können hohe elektrische Ströme auftreten, welche u. U. im Zusammenwirken mit defekten und/oder schadhaften Komponenten der Photovoltaikanlage zu erheblichen Leistungsverlusten führen können. Dies betrifft insbesondere Kontaktwiderstände von Kontakten von Verbindungsstellen von Modulen untereinander wie auch elektrische Leitungsanschlüsse.

Bislang sind keine zufriedenstellenden Verfahren und/oder Vorrichtungen zur Überwachung des Kontaktzustandes an Photovoltaikanlagen bekannt.

Die vorliegende Erfindung zielt darauf ab, dieses Problem zu lösen.

Die Erfindung löst dieses Problem mit einem Verfahren entsprechend dem Anspruch 1 und einer Vorrichtung nach Anspruch 13.

Eine Idee der Erfindung besteht darin, mittels eines in die Photovoltaikanlage eingekoppelten Testsignals mit unterschiedlichen Frequenzen eine Impedanz der Photovoltaikanlage zu ermitteln und daraus den Widerstand der Photovoltaikanlage zu bestimmen und zu überwachen, um so Rückschlüsse auf die Kontakte zu erhalten.

Dazu wird ein Verfahren vorgeschlagen, welches folgende Verfahrensschritte aufweist:
a) Einkoppeln eines Testsignals in die Photovoltaikanlage, wobei das Testsignal mehrere Frequenzen umfasst,
b) Auskoppeln des Testsignals (bzw. des Antwortsignals) aus der Photovoltaikanlage und Ermitteln einer frequenzabhängigen Impedanz der Photovoltaikanlage mittels einer Auswertung des ausgekoppelten Testsignals;
c) Überwachen von Kontakten der Photovoltaikanlage durch Ermitteln eines Widerstands der Photovoltaikanlage anhand der ermittelten Impedanz.

Die Erfindung ermöglicht es, mit Hilfe eines Testsignals auf einfache Weise einen fehlerhaften Kontaktzustand zu ermitteln, und z.B. an einer Ausgabeeinrichtung wie einem Display eines Überwachungsstandes eine Warnmeldung auszugeben, wenn ein fehlerhafter Kontaktzustand vorliegt.

Vorzugsweise wird die Frequenz des Testsignals in Form einer Anzahl von Schwingungsanregungen mit unterschiedlichen, diskreten Frequenzen verändert. Dabei ist es zweckmäßig, wenn die Frequenz des Testsignals über einen Bereich verändert wird, der eine Resonanzfrequenz der photovoltaischen Anlage (1) enthält.

Vorzugsweise werden diese Verfahrensschritte bei Dämmerung und/oder Dunkelheit ausgeführt werden.

In einem Zustand, in welchem eine bzw. die Photovoltaikanlage nicht mit Licht bestrahlt wird, kann diese als ein Reihenschwingkreis mit einem Wirkwiderstand, einem induktiven Blindwiderstand und einem kapazitiven Blindwiderstand als Grundlage dienen, wobei der Wirkwiderstand der Widerstand der Photovoltaikanlage ist.

Dieser Zustand ist in der Dämmerung und bei Dunkelheit gegeben, was durch einen geeigneten Strahlungssensor festgestellt werden kann.

Durch eine Auswertung des ausgekoppelten Testsignals kann - beispielsweise aus der Spannung und dem Strom des ausgekoppelten Testsignals - der Wirkwiderstand, der induktive Blindwiderstand und der kapazitive Blindwiderstand eindeutig bestimmt werden.

Da beim Reihenschwingkreis im Resonanzfall der induktive Blindwiderstand und der kapazitive Blindwiderstand aufgehoben sind, wird die Resonanzfrequenz des Reihenschwingkreises ermittelt. Dies kann anhand des Testsignals und einer damit erzeugten Impedanzkurve leicht ausgeführt werden. Anhand der ermittelten Resonanzfrequenz kann so der Wirkwiderstand der Photovoltaikanlage bestimmt werden.

Beim Überwachen der Kontakte der Photovoltaikanlage können zeitliche Änderungen bestimmter Werte des Wirkwiderstands erfasst und mit vorher festgelegten Referenzwerten verglichen werden, wobei beim Erreichen bestimmter Schwellwerte ein Signal ausgegeben wird.

Das Testsignal kann äquidistante Frequenzstufen aufweisen, wodurch leicht vergleichbare Werte erzeugt werden können.

Das ausgekoppelte Testsignal kann einer Gleichrichtung unterzogen werden. Dies ist mit einem Präzisionsgleichrichter möglich, der auch mit Pegelanpassungen ausgerüstet sein kann.

Der ermittelte Wert des Wirkwiderstands kann mittels einer Temperaturkompensation korrigiert werden, was zum Beispiel mit einer Funktion der ermittelten Impedanz des Reihenschwingkreises durchführbar ist. Die ermittelten Impedanzwerte können auch einem vorher trainierten neuronalen Netzwerk zur Erzeugung eines Korrekturwertes zugeführt werden. Auf diese Weise ist es beispielsweise möglich, Effekte wie den Einfluss der aktuellen Temperatur auf den Wirkwiderstand der Photovoltaikanlage vor dem Vergleich mit Referenzwerten zumindest teilweise zu eliminieren, und so eine zuverlässigere Überwachung zu erreichen.

Eine Vorrichtung zur Überwachung von Kontakten einer Photovoltaikanlage weist Folgendes auf:
- einen Signalgenerator mit einer steuerbaren Quelle zur Erzeugung eines Testsignals mit einer festlegbaren Anzahl von Schwingungsanregungen mit unterschiedlichen Frequenzen;
- einen ersten Übertrager zur Einkopplung des Testsignals in die Photovoltaikanlage;
- einen optionalen zweiten Übertrager zur Auskopplung eines Stroms des Testsignals;
- ein zu Anschlussklemmen der Photovoltaikanlage parallel geschaltetes RC-Glied zur Auskopplung einer Spannung des Testsignals; und
- eine Steuerungseinrichtung; die zur Ermittlung einer Impedanz der Photovoltaikanlage aus dem ausgekoppelten Testsignal und zur Überwachung eines Widerstands der Photovoltaikanlage ausgebildet ist.

Mit dieser Vorrichtung ist es möglich, auf einfache Weise mit Hilfe eines Testsignals, welches in die Elektrik der Photovoltaikanlage eingekoppelt und wieder aus dieser ausgekoppelt wird, einen fehlerhaften Kontakt zu ermitteln, ohne die elektrischen Verbindungen der Photovoltaikanlage auftrennen zu müssen.

Vorzugsweise ist ferner ein Strahlungssensor zur Erfassung von Dämmerung und Dunkelheit vorgesehen.

Die Steuerungseinrichtung kann einen Präzisionsgleichrichter aufweisen. Sie kann ferner wenigstens eine Speichereinrichtung zur Speicherung erfasster und bearbeiteter Testsignalwerte, daraus ermittelter weiterer Werte, sowie zur Speicherung vorher festgelegter Tabellen und Funktionen der Steuerungseinrichtung aufweisen.

Außerdem kann die Steuerungseinrichtung eine Auswertungseinrichtung zur Charakterisierung mindestens einer Eigenschaft, zum Beispiel einer Alterung von Komponenten, der Photovoltaikanlage aufweisen.

Während des Anlagenbetriebs unabhängig vom Betriebszustand des Wechselrichters, vorzugsweise bei Dunkelheit, wird die Impedanz der überwachten Photovoltaikanlage bei variabler Frequenz ermittelt.

Hierzu wird ein Testsignal in den Gleichstromkreis der Photovoltaikanlage eingekoppelt und wieder ausgekoppelt.

Sodann werden zumindest die Parameter Testsignalspannung und Testsignalstrom des ausgekoppelten Testsignals ermittelt.

Die ausgekoppelte Testsignalspannung und der ausgekoppelte Testsignalstrom sind sodann zur Bestimmung der Impedanz in Abhängigkeit von der Frequenz des Testsignals verwendbar.

Die so ausgekoppelten Testsignale werden vorzugsweise jeweils mit einem Präzisionsgleichrichter mit vor- und nachgeschalteter Verstärkung bzw. Pegelanpassung aufbereitet, so dass nicht die kompletten Signalverläufe, sondern nur die Signalamplituden von analog nach digital gewandelt werden.

Es ist ein Vorteil, dass derart einfache, kostengünstige Analog/Digital-Wandler mit geringer Abtastrate für die Messwerterfassung ausreichen. Auf eine Phaseninformation kann vorteilhaft verzichtet werden.

Um bei der Überwachung Änderungen von Kontakten, d.h. Kontaktwiderständen (Steck-, Schraub- und Lötverbindungen) rechtzeitig zu erkennen, ist es vorteilhaft, wenn das verwendete Messverfahren sehr empfindlich und genau ist. Hierzu ist es vorteilhaft, das Minimum der ermittelten Impedanz zu finden.

So wird vorzugsweise in einem gewählten Frequenzbereich pro Messzyklus ein vollständiger Impedanzverlauf ermittelt.

Ein beispielhaftes erfindungsgemäßes Verfahren zur Überwachung von Kontakten, d.h. zur Kontaktfehlererkennung, kann nach einem besonders vorteilhaften, nicht aber zwingenden Ausführungsbeispiel wie folgt ablaufen:
- Zur Anregung wird vorzugsweise ein Testsignal, beispielsweise eine Sinusschwingung, mit vorgegebener Amplitude und variabler Frequenz verwendet.
- Messzyklus: Reihenfolge von Sinusanregungen beginnend mit beispielsweise 10 kHz bis 200 kHz in 10 kHz Schritten mit einer Dauer von beispielsweise 250 ms.
- Ein Messzyklus wird in bestimmten Zeitabständen wiederholt (z.B. 1 min, 3min).
- Es werden die Signale Referenzspannung, Messspannung, Messstrom (des Testsignals) und Frequenzsollwert erfasst.
- Die Berechnung der Impedanz der Photovoltaikanlage erfolgt aus den gleichgerichteten ausgekoppelten Testsignalen.

Testweise durchgeführte Impedanzmessungen an Solargeneratoren und die aufgenommenen Impedanzverläufe haben gezeigt, dass sich das Verhalten der Photovoltaikanlage im untersuchten Frequenzbereich vereinfacht durch einen Reihenschwingkreis beschreiben lässt. Dies kann dazu genutzt werden, eine besonders vorteilhafte Ausgestaltung des erfindungsgemäßen Verfahrens zu schaffen.

Bei dieser Ausgestaltung werden "in der Nähe" des gemessenen Impedanzminimums drei Werte mit jeweils unterschiedlicher Frequenz gesucht, mit deren Hilfe die Parameter R, L und C des Reihenschwingkreises eindeutig bestimmbar sind.

Ein Vorteil dieser Variante des erfindungsgemäßen Verfahrens ist der, dass das Impedanzminimum nicht exakt gemessen werden muss.

Es genügt, wenn der kleinste gemessene Wert in der Nähe des Minimums liegt. So ist es leicht möglich, mit äquidistanten Frequenzstufen den gewünschten Bereich abzutasten. Weiterhin stehen die drei physikalisch begründbaren Parameter R, L und C zur Verfügung, mit denen die charakteristischen Eigenschaften des überwachten Gleichstromkreises der Photovoltaikanlage beschrieben werden können. Bevorzugt wird mindestens ein Messwert bei einer Frequenz bestimmt, die oberhalb der Resonanzfrequenz, und mindestens ein Messwert bei einer Frequenz bestimmt, die unterhalb der Resonanzfrequenz liegt.

Zur Kontaktfehlererkennung werden diese drei Parameter vorzugsweise abhängig von den Umgebungsbedingungen über einen bestimmten Messzeitraum in der Dämmerung und/oder Dunkelheit ermittelt.

Es ist ein vorteilhaftes Ziel dieser Variante, den fehlerfreien Zustand durch möglichst wenige Daten zu charakterisieren.

Zur Auswertung des fehlerfreien Zustands wird vorzugsweise zunächst der zeitliche Verlauf des ermittelten Parameters für den Wirkwiderstand R betrachtet. In Langzeitmessungen über mehrere Monate zeigte sich, dass die so ermittelte Baseline vielen externen Einflüssen (Einstrahlung, Temperatur etc.) unterliegt. Grundlagenuntersuchungen ergaben, dass die Messempfindlichkeit und damit die Erkennbarkeit im Dunkeln und in der Dämmerung (Zeitbereich zwischen Sonnenuntergang und Sonnenaufgang) am höchsten sind.

Bei einem Betrieb in Dunkelheit ist die danach dominierende Einflussgröße auf die Impedanz die Temperatur.

Dieser Einfluss lässt sich, ohne dass die Temperatur separat erfasst werden muss, mit Hilfe eines neuronalen Netzwerks reduzieren. Die drei Parameter R, L und C bilden hierbei die Eingangsgrößen. Als Ausgangsgröße des neuronalen Netzwerks oder Netzes ergibt sich eine temperaturkorrigierte Baseline. Die mit dem neuronalen Netz bestimmte Beziehung lässt sich durch eine Gleichung ausdrücken, mit welcher der Einfluss der Temperatur auf den ermittelten Baseline-Wert R reduziert werden kann. Nachfolgend wird die Erfindung unter Bezugnahme anhand von Ausführungsbeispielen auf die beiliegenden Zeichnungen näher beschrieben. Es zeigen:
- Fig. 1a: ein vereinfachtes elektrisches Schaltbild einer elektrischen Anlage mit einer Photovoltaikanlage mit einem Ausführungsbeispiel der erfindungsgemäßen Vorrichtung;
- Fig. 1b: ein vereinfachtes Ersatzschaltbild einer Photovoltaikanlage;
- Fig. 2: einen beispielhaften Ablaufplan eines erfindungsgemäßen Verfahrens,
- Fig. 3: eine schematische Darstellung einer Testspannung mit verschiedenen Frequenzen über der Zeit,
- Fig. 4: eine beispielhafte grafische Darstellung gemessener und berechneter Werte eines Verlaufs eines Scheinwiderstandes Z in Abhängigkeit von einer Frequenz,
- Fig. 5: eine beispielhafte Schaltung eines Präzisionsgleichrichters mit Pegelanpassung,
- Fig. 6: eine beispielhafte, schematische Darstellung eines neuronalen Netzes zur Temperaturkompensation eines Widerstandswertes,
- Fig. 7: eine beispielhafte Diagrammdarstellung eines gemessenen und eines korrigierten zeitlichen Verlaufs eines Widerstandswertes, und
- Fig. 8: eine beispielhafte Diagrammdarstellung diskreter zeitabhängiger Widerstandsmesswerte mit simulierten Kontaktfehlern.

Vor der Beschreibung bevorzugter Ausführungsbeispiele sei angemerkt, dass nachfolgend einige bevorzugte Ausgestaltungen auch im Detail beschrieben werden, dass die Erfindung aber nicht auf diese Ausgestaltungen beschränkt ist, sondern im Rahmen der Ansprüche beliebig variiert ausgestaltet werden kann. Insbesondere sind Begriffe wie "oben", "unten", "vorne" oder "hinten" nicht einschränkend zu verstehen sondern beziehen sich lediglich auf die jeweils dargestellte Anordnung. Zudem sind, wenn einzelne Bestandteile erläutert werden, diese - wenn nicht anders erwähnt - grundsätzlich auch in mehrfacher Ausgestaltung denkbar. Unter den Schutzbereich fallen zudem auch funktionale Umkehrungen der dargestellten Anordnungen und Verfahren sowie äquivalente Ausgestaltungen.

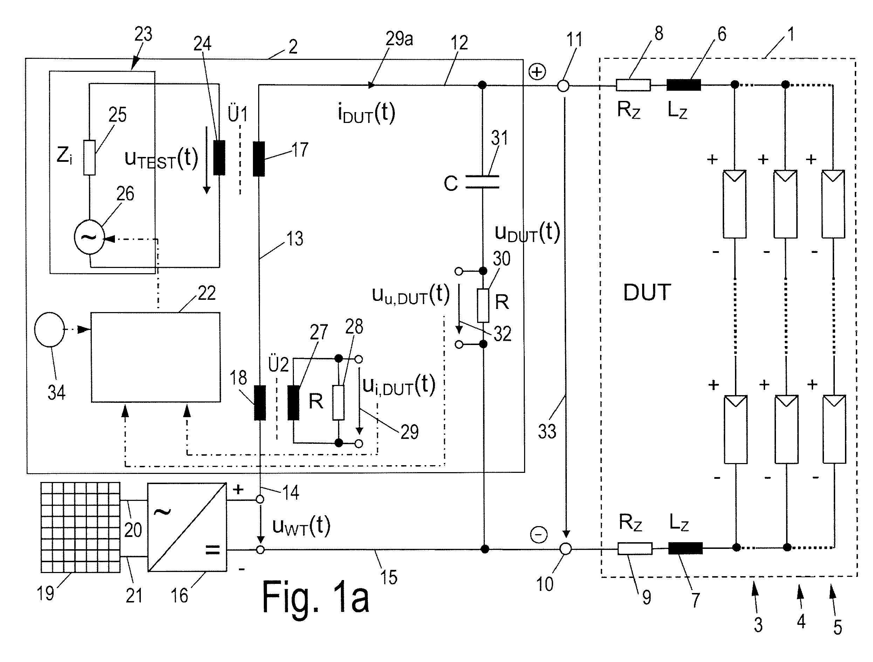

Fig.1a zeigt ein vereinfachtes elektrisches Schaltbild einer elektrischen Anlage mit einer Photovoltaikanlage mit einem Ausführungsbeispiel einer erfindungsgemäßen Vorrichtung. Die Photovoltaikanlage 1 (auch als DUT, Device Under Test bezeichnet), wird mittels eines erfindungsgemäßen Verfahrens überwacht, welches durch eine erfindungsgemäße Vorrichtung 2 ausführbar ist.

Die Photovoltaikanlage 1 weist eine Anzahl von Photovoltaikmodulen 3...5 (so genannte Strings) auf, von denen hier nur drei gezeigt und die entsprechend bestehenden Anforderungen verschaltet sind. Die Photovoltaikanlage 1 weist Leitungsinduktivitäten L_{z} 6, 7 und Leitungswirkwiderstände R_{z} 8, 9 auf.

Eine negative Anschlussklemme 10 der Photovoltaikanlage 1 ist über einen elektrischen Leiter 15 mit einem negativen Gleichspannungseingang eines Wechselrichters 16 elektrisch verbunden. Entsprechend ist eine positive Anschlussklemme 11 der Photovoltaikanlage 1 über elektrische Leiter 12, 13 und 14 mit einem positiven Gleichspannungseingang des Wechselrichters 16 verbunden. Eingeschleift in den positiven Zweig (11, 12, 13, 14) ist eine Sekundärwicklung 17 eines Übertragers Ü1 und eine Primärwicklung 18 eines Übertragers Ü2. Die genannten Wicklungen sind so dimensioniert, dass sie die Wirkungsweise der Photovoltaikanlage 1, insbesondere hinsichtlich auftretender Verluste, nicht nennenswert beeinflussen. Die Funktion der Übertrager Ü1 und Ü2 wird später noch im Detail erläutert. Einer der beiden Übertrager Ü1, Ü2 oder beide können ebenso im negativen Zweig der Photovoltaikanlage 1 eingeschleift sein.

Der Wechselrichter 16 ist mit einem elektrischen Netz 19, beispielsweise mit dem öffentlichen Elektrizitätsnetz, über elektrische Leiter 20, 21 verbunden, um eine von der Photovoltaikanlage 1 in Form einer Gleichspannung bereitgestellte elektrische Leistung entsprechend bestehender Vorgaben zu wandeln und in das elektrische Netz 19 einzuspeisen.

Zur Überwachung der Photovoltaikanlage 1 dient eine Vorrichtung 2. Sie weist einen von einer Steuerungseinrichtung 22 ansteuerbaren Signalgenerator 23 auf, welcher eine Testspannung u_{TEsT}(t) über eine Primärwicklung 24 in den Gleichstromkreis (1, 11, 12, 13, 14, 15, 10) einspeist. Der Signalgenerator 23 weist einen Scheininnenwiderstand Zᵢ 25 und eine durch die Steuerungseinrichtung 22 steuerbare Quelle 26 auf, welche hier eine Spannungsquelle ist.

Zur messtechnischen Erfassung der Reaktion der Photovoltaikanlage 1 (DUT) auf die Testspannung u_{TEST}(t) wird über eine Sekundärwicklung 27 des Übertragers Ü2 und einen hierzu parallel geschalteten Widerstand R 28, eine Spannung uᵢ,_{DUT}(t) 29 ausgekoppelt, die bei Kenntnis der Übertragungsfunktion der Anordnung Ü2 und Widerstand 28 eine messtechnische Erfassung des Stromes i_{DUT}(t) 29a ermöglicht. Die Spannung uᵢ,_{DUT}(t) 29 wird an die Steuerungseinrichtung 22 geleitet (Strichpunktlinien) und dort weiterverarbeitet. Weiterhin wird über ein parallel zu den Klemmen 10 und 11 geschaltetes Messglied, hier ein aus einem Widerstand 30 und einer Kapazität 31 bestehendes RC-Glied, eine Spannung uᵤ,_{DUT}(t) 32 ausgekoppelt, die bei Kenntnis der Übertragungsfunktion des Messglieds, hier des aus dem Widerstand 30 und der Kapazität 31 bestehenden RC-Glieds, eine messtechnische Erfassung der Spannung u_{DUT}(t) 33 ermöglicht. Die Spannung u_{u,DUT}(t) 32 wird ebenfalls an die Steuerungseinrichtung 22 geleitet (Strichpunktlinie) und dort weiterverarbeitet. Angeschlossen an die Steuerungseinrichtung 22 ist optional weiterhin ein Strahlungssensor 34, mittels dessen die Steuerungseinrichtung 22 über eine Information verfügt, ob aktuell ein Tagzustand oder ein Nachtzustand vorliegt. Alternativ kann diese Information auch aus einer Uhrzeit oder dem Photostrom der Photovoltaikanlage 1 ermittelt werden.

In einer vorteilhaften Ausgestaltung der Erfindung kann die Vorrichtung 2 inklusive Signalgenerator 23 und Steuereinrichtung 22 in das Gehäuse des Wechselrichters 16 integriert sein, aber eine Anordnung dieser Komponenten ganz oder teilweise außerhalb des Gehäuses des Wechselrichters 16 ist ebenfalls denkbar.

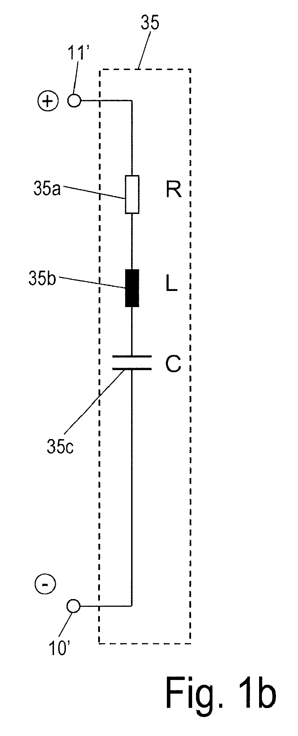

Fig. 1b illustriert ein vereinfachtes Ersatzschaltbild einer Photovoltaikanlage 1, welches im Rahmen der Entwicklungsarbeiten zur vorliegenden Erfindung festgestellt wurde, nämlich, dass sich ein elektrisches Verhalten der Photovoltaikanlage 1 mittels einer Reihenschaltung 35 aus einem Wirkwiderstand R 35a, einer Induktivität L 35b und einer Kapazität C 35c nachbilden lässt. Eine derartige mit dem Bezugszeichen 35 bezeichnete Anordnung wird als Reihenschwingkreis bezeichnet. Ein wie vorstehend beschriebener Reihenschwingkreis kann daher als elektrisches Ersatzschaltbild für eine Photovoltaikanlage 1 verwendet werden. Die Ersatzschaltung verhält sich dann - in gewissen Grenzen - elektrisch identisch zu der hierdurch nachgebildeten Photovoltaikanlage 1. Insbesondere lässt sich mittels eines Reihenschwingkreises 35 das elektrische Verhalten einer Photovoltaikanlage 1 bei Dunkelheit nachbilden, also dann, wenn die Photovoltaikanlage 1 keiner Bestrahlung durch die Sonne ausgesetzt ist.

Bei dem Reihenschwingkreis 35 besteht die Gesamtimpedanz aus der Summe des induktiven Blindwiderstands 35b, des kapazitiven Blindwiderstands 35c und des ohmschen Widerstands 35a. Im Resonanzfall, d.h. bei der Resonanzfrequenz des Reihenschwingkreises, heben sich der kapazitive und der induktive Blindwiderstand gegenseitig auf, wobei der ohmsche Widerstand bzw. Wirkwiderstand 35a verbleibt. Zusammengefasst ausgedrückt wird erfindungsgemäß vorgeschlagen, den Wirkwiderstand 35a des Reihenschwingkreises 35 bei der Resonanzfrequenz zu bestimmen und dann auf Grund des ermittelten Wirkwiderstandes 35a eine Aussage über den Zustand der Kontakte der Photovoltaikanlage 1 zu treffen.

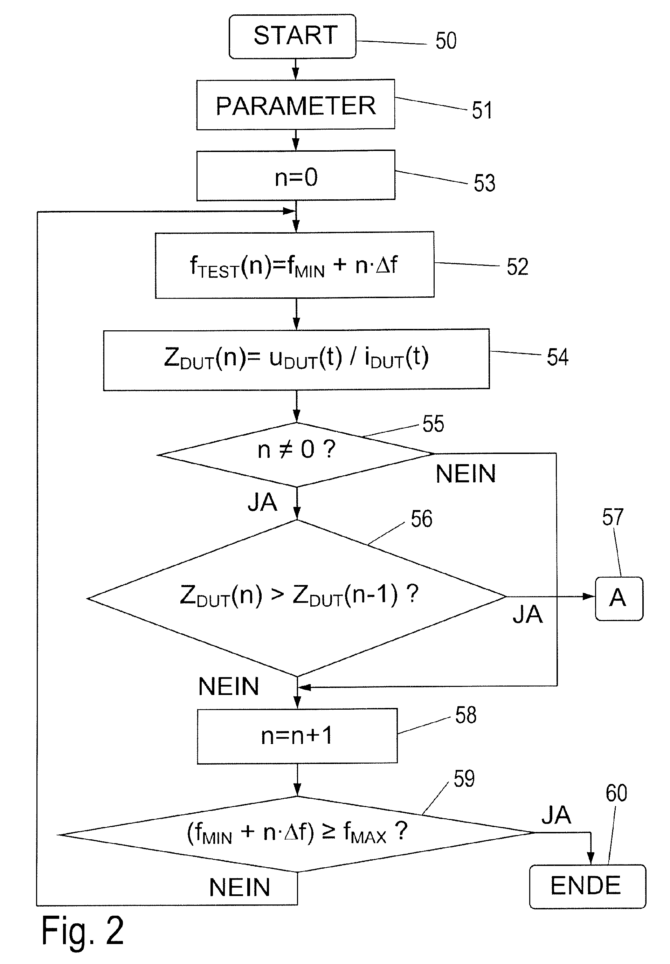

Dies wird im Folgenden unter Bezugnahme auf Fig. 2, welche einen beispielhaften Ablaufplan eines erfindungsgemäßen Verfahrens darstellt, detailliert erläutert.

Die einzelnen Schritte des Ablaufplans können beispielsweise in Form eines Computerprogramms in einer nicht dargestellten Mikrocomputereinrichtung der Steuerungseinrichtung 22 (vgl. Fig. 1) gespeichert sein.

Dargestellt ist der Ablauf eines Messzyklus. Unter einem Messzyklus wird im Rahmen der vorliegenden Erfindung verstanden, die DUT mit einer Testspannung u_{TEST}(t) zu beaufschlagen, wobei die Frequenz der Testspannung u_{TEST}(t) ausgehend von einer minimalen Frequenz f_{MIN} schrittweise um eine Schrittweite Δf bis zu einer maximalen Frequenz f_{MAX} erhöht wird.

In einem START-Schritt 50 wird von der Steuerungseinrichtung 22 der Start eines Messzyklus veranlasst. In einem weiteren Schritt 51 werden Parameter für den aktuellen Messzyklus festgelegt, beispielsweise - abhängig vom Typ der zu überwachenden Photovoltaikanlage 1 - aus einer Look-Up-Tabelle der Steuerungseinrichtung 22 eingelesen. Insbesondere handelt es sich hierbei um die Parameter f_{MIN}, f_{MAX}, Δf, sowie eine Amplitude û eines Testsignals mit einer Testspannung u_{TEST}(t). In diesem Schritt können ggf. weitere Parameter festgelegt werden.

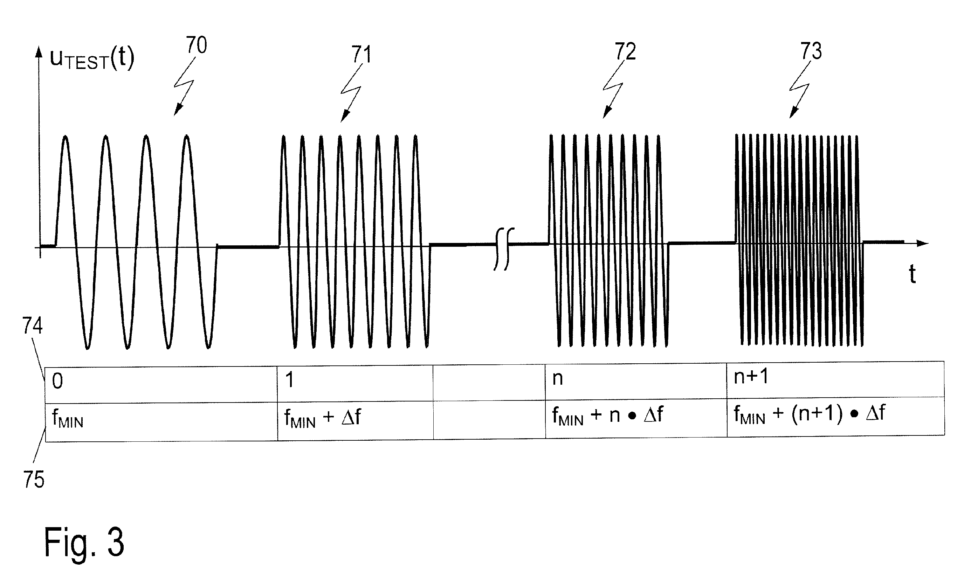

Zur Erläuterung der Testspannung u_{TEST}(t) wird nun Bezug auf Fig. 3 genommen. Gezeigt ist beispielhaft eine Testspannung u_{TEST}(t) in Form eines Spannungs-ZeitDiagramms mit verschiedenen Frequenzen. Dargestellt sind eine Anzahl von Schwingungsanregungen 70, 71, 72 und 73, hier als Sinusanregungen ausgebildet. Die Frequenz der Schwingungsanregungen nimmt von links nach rechts zu. In der Zeile 74 ist ein Wert des Zählers n dargestellt und in der Zeile 75 eine Berechnungsvorschrift zur Berechnung der aktuellen Frequenz der aktuellen Schwingungsanregung, ausgehend von den bekannten Parametern und dem entsprechenden Wert des Zählers n. Auf diese Weise wird ein Testsignal geschaffen, bestehend aus einer Anzahl von Schwingungsanregungen, deren Frequenz schrittweise zunimmt. Ggf. sind zeitliche Pausen zwischen den Schwingungsanregungen ebenfalls festlegbar und variierbar.

Nun wird wieder Bezug auf Fig. 2 genommen. Im nachfolgenden Schritt 52 wird ein Zähler n auf null gesetzt. Im Schritt 53 wird ausgehend vom Zählerstand n die Frequenz für die erste Schwingungsanregung (vgl. Fig. 3) festgelegt. Im Schritt 54 wird über die Gleichung Z_{DUT}(n) = |u_{DUT}(n)| / |i_{DUT}(n)| der Betrag des aktuellen Scheinwiderstandes Z_{DUT}(n), d.h. der für den aktuellen Frequenzwert f(n) herrschende Scheinwiderstand Z_{DUT}(n) ermittelt. Z_{DUT}(n), f(n) und ggf. die Effektiv- oder Amplitudenwerte u_{DUT}(n) und i_{DUT}(n) der gemessenen Augenblickswerte u_{DUT}(t) und i_{DUT}(t) werden für Berechnungen in den nachfolgenden Schritten gespeichert, beispielsweise in einer nicht dargestellten Speichereinrichtung der Steuerungseinrichtung 22 (vgl. Fig. 1). In der Verzweigung 55 wird überprüft ob der Zähler n gleich Null ist. Für diesen Fall wird die nachfolgende Abfrage 56 übersprungen, da für einen Vergleich von zwei Scheinwiderständen Z_{DUT}(n) noch keine ausreichende Anzahl von Werten für Z_{DUT}(n) im Speicher vorhanden ist. Ist der Wert n größer Null so wird in der Abfrage 56 überprüft ob der aktuell gemessene Wert für Z_{DUT}(n) größer als der zuvor gemessene und gespeicherte Wert Z_{DUT}(n-1) ist. Für den Fall, dass diese Bedingung erfüllt ist, wird davon ausgegangen, dass die aktuelle Frequenz in der Nähe (die Genauigkeit hängt von dem für den Parameter Δf gewählten Wert ab) der Resonanzfrequenz des Ersatzschaltbildes liegt, also des Reihenschwingkreises 35, der ein elektrisches Verhalten der zu überwachenden Photovoltaikanlage 1 nachbildet. Da der Scheinwiderstand Z eines Reihenschwingkreises 35 seinem Wirkwiderstand entspricht, wenn dieser mit einem Signal angeregt wird, das seine Resonanzfrequenz aufweist, werden die drei letzten ermittelten Impendanzwerte Z_{DUT} zur Bestimmung des induktiven Blindwiderstands 35b, des kapazitiven Blindwiderstands 35c und des ohmschen Widerstands 35a herangezogen. So liegt nun, d. h. wenn in der Verzweigung 56 eine Verzweigung nach A 57 erfolgt, der Wirkwiderstand des Gleichstromkreises der zu überwachenden Photovoltaikanlage 1 vor und kann im Schritt 57 A weiterverarbeitet und ausgewertet werden. Dies wird weiter unten noch detailliert ausgeführt.

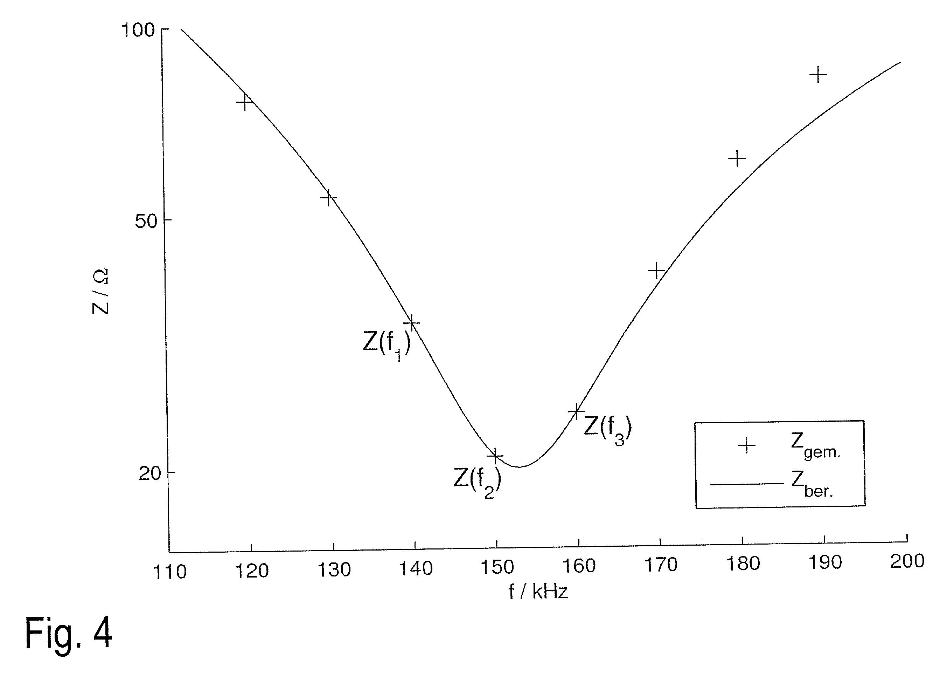

Zur Erläuterung des zuvor gesagten wird nun Bezug auf Fig. 4 genommen. Hier ist beispielhaft eine Darstellung von gemessenen und berechneten Werten eines Verlaufs eines Scheinwiderstandes Z eines Reihenschwingkreises 35 in Abhängigkeit von einer Frequenz in Form eines Diagramms gezeigt. Deutlich sichtbar ist der bekannte Verlauf des Scheinwiderstandes Z, der im Bereich der Resonanzfrequenz (also im Bereich Z(f₂) minimal wird und links und rechts, d.h. unterhalb bzw. oberhalb der Resonanzfrequenz ansteigt. Wird also im Schritt 56 (vgl. Fig. 2) Z(f₂) mit Z(f₃) verglichen, so wird festgestellt, dass der zuletzt gemessene Scheinwiderstand Z(f₃) größer als der zuvor gemessene Scheinwiderstand Z(f₂) ist. Hieraus wird geschlossen, dass das Minimum des Scheinwiderstandes gerade durchschritten wurde und somit eine genaue Bestimmung des induktiven Blindwiderstands 35b, des kapazitiven Blindwiderstands 35c und des ohmschen Widerstands 35a durchgeführt werden kann.

Führt der Vergleich in Fig. 2 in der Abzweigung 56 zu dem Ergebnis, dass der aktuell gemessenen Wert des Scheinwiderstandes Z_{DUT}(n) kleiner als der zuvor gemessene Wert Z_{DUT}(n-1) ist, so liegt die aktuelle Frequenz noch nicht im Bereich der Resonanz, so dass ein weiterer Durchlauf erforderlich ist. Im nachfolgenden Schritt wird der Zähler n um Eins erhöht und im darauf folgenden Schritt 59 wird geprüft, ob mit dem neuen Zählerwert eine maximale Frequenz f_{MAX} des Testsignals überschritten wird. Ist dies der Fall, so wird - ggf. mit einer Fehlermeldung und/oder weiteren Schritten zum Ende 60 des aktuellen Messzyklus verzweigt. Ist dies nicht der Fall, so wird zu einem neuen Durchlauf oberhalb des Schrittes 53 verzweigt, wo wie bereits ausgeführt, die aktuelle Frequenz des Testsignals um einen Schritt Δf erhöht wird.

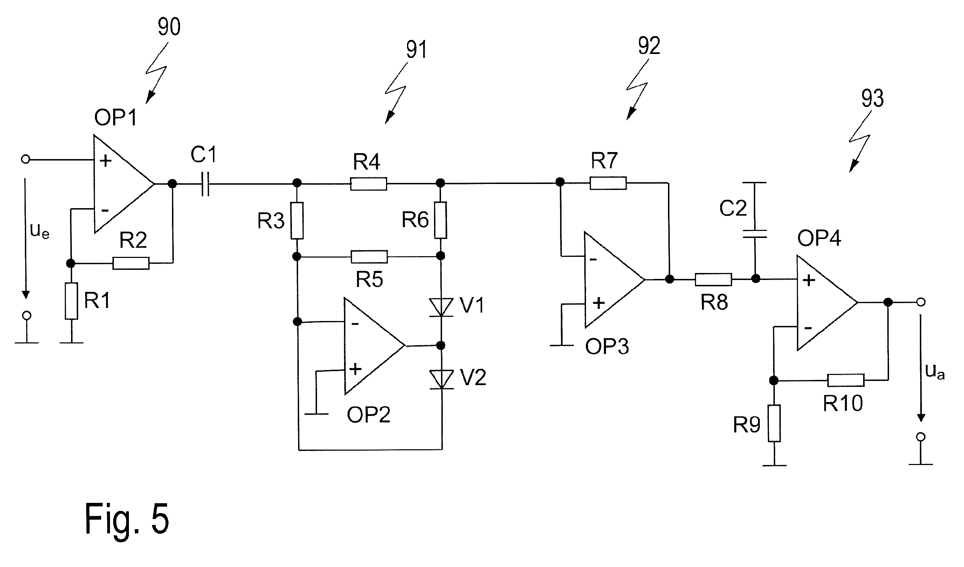

Bezug wird jetzt auf Fig. 5 genommen, die beispielhaft eine Schaltung zur Aufbereitung der gemessenen Spannungen U_{u,DUT}(t) 32 und/oder u_{i,DUT}(t) 29 (vgl. beide Fig. 1) zeigt. Die Schaltung kann beispielsweise in der Steuerungseinrichtung 22 (Fig. 1) angeordnet sein. Hierbei liegt dann am Eingang der Schaltung uₑ die Spannung u_{u,DUT}(t) 32 oder u_{i,DUT}(t) 29 (vgl. beide Fig. 1), wobei der Ausgang der Schaltung uₐ beispielsweise mit einem Analog/Digitalwandler (nicht gezeigt) der Steuerungseinrichtung 22 verbunden ist.

Eine Baugruppe 90 weist einen Operationsverstärker OP1 und eine dazugehörige Beschaltung R1 und R2 auf. Baugruppe 90 stellt einen nicht invertierenden Verstärker zur Pegelanpassung des Eingangssignals uₑ dar, das Ausgangssignal dieser Baugruppe ist wechselspannungsmäßig über einen Kondensator C1 an eine nachfolgende Baugruppe 91 angekoppelt. Baugruppe 91 stellt mit einem Operationsverstärker OP2 und dessen Beschaltung R3, R4, R5, R6, V1 und V2 zusammen mit der Baugruppe 92 und dessen Beschaltung R7 einen Gleichrichter dar. Anschließend findet mit dem Tiefpass R8 und C2 eine Mittelwertbildung zur Glättung des Signals statt. Mittels Baugruppe 93 mit einem Operationsverstärker OP4 und dessen Beschaltung R9 und R10 findet eine erneute Pegelanpassung des Ausgangssignals _{Ua} an eine nachfolgende Einrichtung, beispielsweise, wie bereits ausgeführt, an einen nicht dargestellten Analog/Digitalwandler statt.

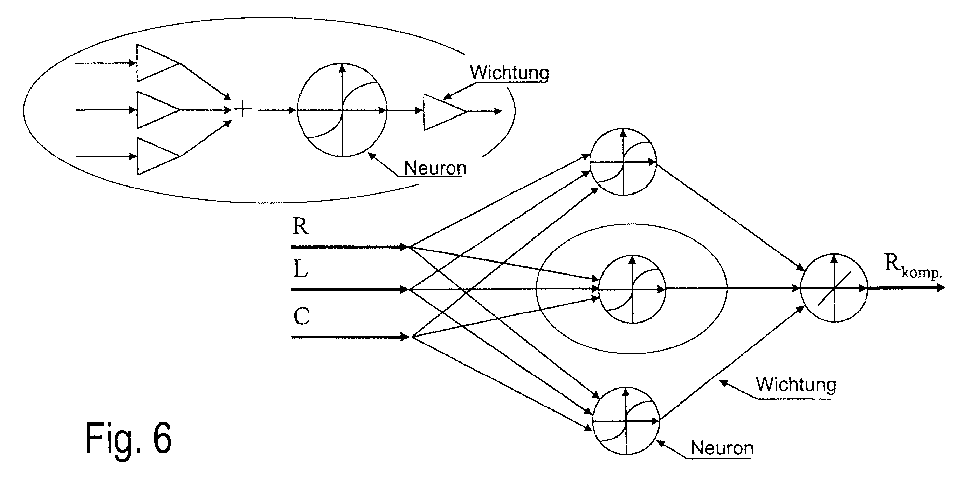

Fig. 6 zeigt eine Möglichkeit eine ggf. erforderliche Temperaturkompensation eines ermittelten Widerstandswertes mittels eines neuronalen Netzes vorzunehmen. Gezeigt ist ein neuronales Netz mit den Eingängen R, L und C. Diese Werte werden verwendet, um ohne eine tatsächliche Temperaturmessung eine Aussage über eine ggf. erforderliche Korrektur eines ermittelten Widerstandswertes zu machen. So kann ein ermittelter Widerstandswert ggf. mit einem mittels des neuronalen Netzes ermittelten Korrekturwerts korrigiert werden.

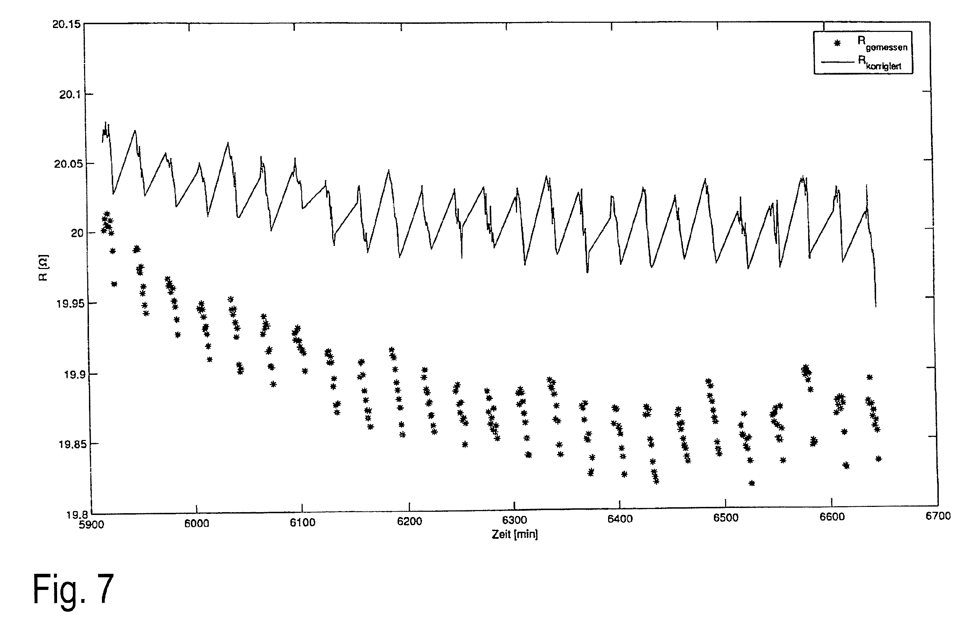

Fig. 7 zeigt beispielhaft einen Verlauf von gemessenen Widerstandswerten (unterer Verlauf) und einen Verlauf von Widerstandswerten, der mittels eines neuronalen Netzes angepasst wurde (oberer Verlauf). Während der gemessene Widerstandswert (*) zwischen 19,82 Ohm und 20,02 Ohm variiert, liegen die korrigierten Werte (durchgezogene Linie) in einem engen Bereich zwischen 19,97 Ohm und 20,08 Ohm.

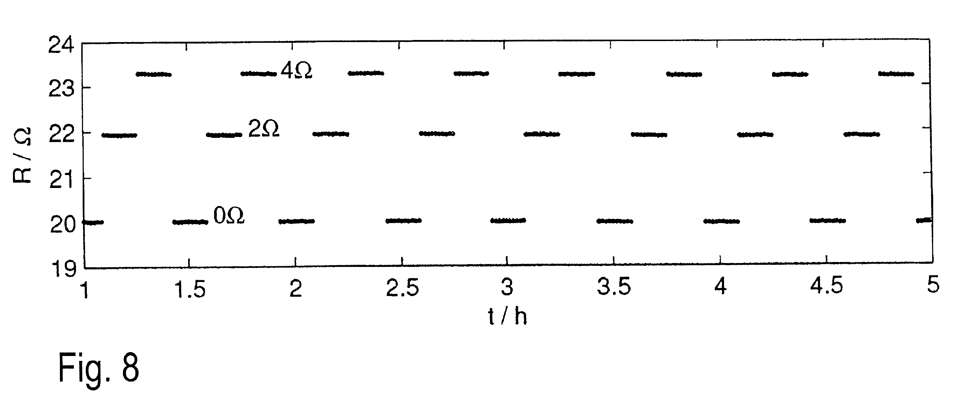

Fig. 8 zeigt eine Darstellung diskreter Widerstandswerte, die mittels der Erfindung ermittelt wurden. Zur Simulation eines Kontaktfehlers wurden über einen Zeitraum von 5 Std. zusätzliche Widerstände von jeweils 0 Ohm, 2 Ohm und 4 Ohm für einen jeweils kurzen Zeitraum in den Gleichstromkreis einer zu überwachenden Photovoltaikanlage eingeschleift. Der dargestellte Verlauf der gemessenen Widerstände zeigt deutlich die Erkennungsgenauigkeit des erfindungsgemäßen Verfahrens.

Der ermittelte Widerstandswert für den Scheinwiderstand Z im Resonanzbereich einer Photovoltaikanlage 1 (DUT) erlaubt Rückschlüsse u. A. auf den Zustand des Stromkreises der Photovoltaikanlage 1, insbesondere der Kontaktwiderstände, und auch der Anschlussleitungen. Erhöht sich der ohmsche Widerstand R (Wirkwiderstand 35a) einer Photovoltaikanlage 1 (DUT), so kann hieraus auf erhöhte Kontaktwiderstände geschlossen werden und eine Warnung ausgegeben werden, eine Abschaltung erfolgen und/oder eine Überprüfung der Photovoltaikanlage 1 und ihrer Beschaltung bzw. Leitungen und Anschlüsse erfolgen.

Die oben beschriebenen Ausführungen sind nur beispielhaft und grenzen die Erfindung nicht ein. Sie kann auf vielfältige Weise im Rahmen der Ansprüche modifiziert werden.

So kann zum Beispiel das Testsignal eine andere Schwingungsform aufweisen, beispielsweise rechteckförmig, dreieckförmig u. dgl.

Es ist auch denkbar, dass ein Einkoppeln und Auskoppeln des Testsignals mittels eines einzigen Übertragers erfolgen kann.

Die Steuerungseinrichtung 22 kann auch eine Auswerteeinrichtung aufweisen, welche anhand der ermittelten Werte über längere Zeiträume weitere Eigenschaften der Photovoltaikanlage (1) charakterisieren kann, wie beispielsweise Alterung der Komponenten.

### Bezugszeichen

- 1: Photovoltaikanlage
- 2: Vorrichtung
- 3...5: Photovoltaikmodul
- 6, 7: Induktivität L_{z}
- 8, 9: Widerstand R_{z}
- 10, 11: Anschlussklemme
- 12...15: Elektrischer Leiter
- 16: Wechselrichter
- 17: Sekundärwicklung Übertrager Ü1
- 18: Primärwicklung Übertrager Ü2
- 19: Elektrisches Netz
- 20, 21: Elektrischer Leiter
- 22: Steuerung
- 23: Signalgenerator
- 24: Primärwicklung Übertrager Ü1
- 25: Scheininnenwiderstand Zᵢ
- 26: Steuerbare Quelle
- 27: Sekundärwicklung Übertrager Ü2
- 28: Widerstand
- 29: Spannung u_{i,DUT}(t)
- 29a: Strom i_{DUT}(ₜ)
- 30: Widerstand
- 31: Kondensator
- 32: Spannung u_{u,DUT}(t)
- 33: Spannung u_{DUT}(t)
- 34: Strahlungssensor
- 35: Reihenschwingkreis
- 35a: Wirkwiderstand
- 35b: Induktiver Blindwiderstand
- 35c: Kapazitiver Blindwiderstand
- 50...60: Verfahrensschritte
- 70...73: Schwingungsanregungen
- 74: Zählerwert
- 75: Berechnungsvorschrift
- 90: Pegelanpassung Eingangssignal
- 91, 92: Präzisionsgleichrichter
- 93: Mittelwertbildung und Pegelanpassung Ausgangssignal

## Patentansprüche

1. Verfahren zur Überwachung von Kontakten einer Photovoltaikanlage (1), mit folgenden Verfahrensschritten:
a) Einkoppeln eines Testsignals in die Photovoltaikanlage (1), wobei die Frequenz des Testsignals während des Einkoppelns verändert wird,
b) Auskoppeln des Testsignals aus der Photovoltaikanlage (1) und Ermitteln einer Impedanz der Photovoltaikanlage (1) mittels einer Auswertung des ausgekoppelten Testsignals;
c) Überwachen von Kontakten der Photovoltaikanlage (1) durch Ermitteln eines Widerstands der Photovoltaikanlage (1) anhand der ermittelten Impedanz.

2. Verfahren nach Anspruch 1, **dadurch gekennzeichnet, dass** die Verfahrensschritte des Anspruchs 1 bei Dämmerung und/oder Dunkelheit ausgeführt werden.

3. Verfahren nach Anspruch 1 oder 2, **dadurch gekennzeichnet, dass** die Frequenz des Testsignals in Form einer Anzahl von Schwingungsanregungen mit unterschiedlichen, diskreten Frequenzen verändert wird.

4. Verfahren nach einem der Ansprüche 1 bis 3 **dadurch gekennzeichnet, dass** beim Ermitteln der Impedanz der Photovoltaikanlage (1) mittels eines Auswertens des ausgekoppelten Testsignals ein Reihenschwingkreis (35) mit einem Wirkwiderstand (35a), einem induktiven Blindwiderstand (35b) und einem kapazitiven Blindwiderstand (35c) als Ersatzschaltbild für die Photovoltaikanlage (1) verwendet wird, wobei der Wirkwiderstand (35a) repräsentativ für den Widerstand der Photovoltaikanlage (1) ist.

5. Verfahren nach einem der Ansprüche 1 bis 4, **dadurch gekennzeichnet, dass** die Frequenz des Testsignals über einen Bereich verändert wird, der eine Resonanzfrequenz der photovoltaischen Anlage (1) enthält.

6. Verfahren nach Anspruch 5, **dadurch gekennzeichnet, dass** die Auswertung des ausgekoppelten Testsignals sowohl bei einer Frequenz oberhalb, als auch bei einer Frequenz unterhalb der Resonanzfrequenz der photovoltaischen Anlage(1) erfolgt.

7. Verfahren nach Anspruch 5 oder 6, **dadurch gekennzeichnet, dass** anhand des Impedanzverlaufes im Bereich der ermittelten Resonanzfrequenz der Wirkwiderstand (35a) der Photovoltaikanlage (1) bestimmt wird.

8. Verfahren nach einem der Ansprüche 1 bis 7, **dadurch gekennzeichnet, dass** beim Überwachen der Kontakte der Photovoltaikanlage (1) zeitliche Änderungen bestimmter Werte des Wirkwiderstands (35a) erfasst und mit vorher festgelegten Referenzwerten verglichen werden, wobei ein Signal ausgegeben wird, wenn der ermittelte Widerstand der Photovoltaikanlage (1) einen Schwellwert übersteigt.

9. Verfahren nach einem der vorhergehenden Ansprüche, **dadurch gekennzeichnet, dass** das Testsignal äquidistante Frequenzstufen aufweist und/oder dass das ausgekoppelte Testsignal einer Gleichrichtung unterzogen wird.

10. Verfahren nach einem der Ansprüche 4 bis 9, **dadurch gekennzeichnet, dass** der ermittelte Wert des Wirkwiderstands (35a) mittels einer Temperaturkompensation korrigiert wird.

11. Verfahren nach Anspruch 10, **dadurch gekennzeichnet, dass** die Temperaturkompensation mit einer Funktion der ermittelten Parameter des Reihenschwingkreises (35) Wirkwiderstand (35a), induktiver Blindwiderstand (35b) und kapazitiver Blindwiderstand (35c) durchgeführt wird.

12. Verfahren nach Anspruch 11, **dadurch gekennzeichnet, dass** die Temperaturkompensation mit einer Funktion der ermittelten Impedanz des Reihenschwingkreises (35) mit Hilfe eines vorher trainierten neuronalen Netzwerks durchgeführt wird.

13. Vorrichtung (2) zur Überwachung von Kontakten einer Photovoltaikanlage (1), aufweisend:
- einen Signalgenerator (23) mit einer steuerbaren Quelle (26) zur Erzeugung eines Testsignals mit veränderlicher Frequenz, und mit einem ersten Übertrager (Ü1) zur Einkopplung des Testsignals in die Photovoltaikanlage (1);
- einen zweiten Übertrager (Ü2) zur Auskopplung eines Stroms des Testsignals;
- ein zu Anschlussklemmen (10, 11) der Photovoltaikanlage (1) parallel geschaltetes Messglied zur Auskopplung einer Spannung des Testsignals; und
- eine Steuerungseinrichtung (22), welche zur Ermittlung einer Impedanz der Photovoltaikanlage (1) aus dem ausgekoppelten Testsignal und zur Überwachung eines Widerstands der Photovoltaikanlage (1) ausgebildet ist.

14. Vorrichtung (2) nach Anspruch 13, **gekennzeichnet durch** einen Strahlungssensor (34) zur Erfassung von Dämmerung und Dunkelheit,

15. Vorrichtung (2) nach Anspruch 13 oder 14, **dadurch gekennzeichnet, dass** die Steuerungseinrichtung (22) einen Präzisionsgleichrichter (91, 92) zur Gleichrichtung des ausgekoppelten Testsignals aufweist.

16. Vorrichtung (2) nach Anspruch 13, 14 oder 15, **dadurch gekennzeichnet, dass** die Steuerungseinrichtung (22) mindestens eine Speichereinrichtung zur Speicherung erfasster und bearbeiteter Testsignalwerte, daraus ermittelter weiterer Werte, sowie zur Speicherung vorher festgelegter Tabellen und Funktionen aufweist.

17. Vorrichtung (2) nach einem der Ansprüche 13 bis 16, **dadurch gekennzeichnet, dass** die Steuerungseinrichtung (22) eine Auswerteeinrichtung zur Charakterisierung mindestens einer Eigenschaft, zum Beispiel einer Alterung von Komponenten, der Photovoltaikanlage (1) aufweist.

18. Vorrichtung nach einem der Ansprüche 13 bis 17, **dadurch gekennzeichnet, dass** die Vorrichtung in einen Wechselrichter (16) integriert ist.
